# EUROPEAN PATENT SPECIFICATION

(11) **EP 3 076 238 B1**
(45) Date of publication and mention of the grant of the patent: **29.08.2018**
(21) Application number: 16000752.2
(22) Date of filing: 31.03.2016
(51) Int. Cl.: G03F 7/00

(54) **IMPRINT MATERIAL DISCHARGING DEVICE**
PRÄGEMATERIALAUSGABEVORRICHTUNG
DISPOSITIF DE DISTRIBUTION DE MATÉRIAU D'EMPREINTE

(30) Priority: 03.04.2015 JP 2015076992; 08.01.2016 JP 2016002753
(43) Date of publication of application: 05.10.2016
(73) Proprietor: Canon Kabushiki Kaisha, Ohta-ku Tokyo (JP)
(72) Inventor: Arai, Tsuyoshi, Tokyo (JP); Mita, Yutaka, Tokyo (JP); Takahashi, Yuichi, Tokyo (JP); Araki, Yoshimasa, Tokyo (JP); Ishibashi, Tohru, Tokyo (JP)
(74) Representative: WESER & Kollegen

(56) References cited:
- JP-A- 2014 216 471
- US-A1- 2010 102 471

## Description

### BACKGROUND OF THE INVENTION

### Field of the Invention

The present invention relates to an imprint material discharging device that discharges an imprint material.

### Description of the Related Art

A so-called imprint technique, in which, in a process for manufacturing, for example, a semiconductor device, a mold having a pattern is brought into contact with an imprint material on a substrate and the shape of the mold is transferred to the imprint material to form a pattern thereon, is known. As an imprint material discharging device that discharges an imprint material onto a substrate, a discharging device using an inkjet head is described in Japanese Patent Laid-Open No. 2014-216471.

The inkjet head of the discharging device that is described in Japanese Patent Laid-Open No. 2014-216471 includes energy generating elements that generate energy for discharging the imprint material onto the substrate. In such a discharging device, when foreign substance is contained in the imprint material, a proper pattern may not be formed when the mold is brought into contact with the imprint material. Therefore, in the discharging device that is described in Japanese Patent Laid-Open No. 2014-216471, the imprint material from which the foreign substance has been removed by a filter is supplied to a container section.

Additionally, US 2010/0102471 A1 relates to imprint lithography systems and methods for transporting and dispensing a polymerizable material on a substrate utilizing, when dispensing the polymerizable material, a dispense head, dispense guard, and a shielding block.

### SUMMARY OF THE INVENTION

The present invention in its first aspect provides an imprint material discharging device as specified in claims 1 to 23.

The present invention in its second aspect provides an imprint apparatus as specified in claims 24 to 26.

Further features of the present invention will become apparent from the following description of exemplary embodiments with reference to the attached drawings.

### BRIEF DESCRIPTION OF THE DRAWINGS

Fig. 1 illustrates a structure of an imprint apparatus.
Fig. 2 illustrates a structure of an imprint material discharging device.
Fig. 3 illustrates a state of circulation of an imprint material.
Fig. 4 illustrates a state of circulation of the imprint material.
Fig. 5 illustrates a state of circulation of the imprint material.
Figs. 6A and 6B illustrate a state of circulation and a state of discharge of the imprint material.
Fig. 7 illustrates a state of circulation and a state of discharge of the imprint material.
Figs. 8A and 8B illustrate a state of discharge of the imprint material from the imprint material discharging device.
Fig. 9 illustrates another structure of the imprint material discharging device.
Fig. 10 illustrates a state in which the imprint material is discharged to the imprint material discharging device.
Fig. 11 illustrates another structure of the imprint apparatus.
Fig. 12 illustrates another structure of the imprint material discharging device.
Fig. 13 illustrates a structure of an imprint material discharging device according to a comparative example.
Fig. 14 illustrates a structure of an imprint material discharging device according to a comparative example.

### DESCRIPTION OF THE EMBODIMENTS

Studies conducted by the inventor et al. have revealed that discharging devices such as that described in Japanese Patent Laid-Open No. 2014-216471 have the following problems. For example, when an imprint material or an imprint material container section in which the imprint material is contained is left unattended for a long period of time, a portion of the imprint material may change with time and become gelated in the imprint material container section. In addition, the imprint material may become contaminated by foreign substance that is produced in the container section. When, in such a state, the imprint material is discharged onto a substrate, a mold with which the imprint material is brought in to contact may become damaged, and the patterning precision of the imprint material may be reduced.

According to the method that is described in Japanese Patent Laid-Open No. 2014-216471, since the imprint material passes through the filter before entering the container section, the foreign substance or the like has been removed when the imprint material enters the container section. However, as described above, it is difficult to handle foreign substance that is produced in the container section and to deal with changes in the imprint material with time.

According to the studies conducted by the inventor et al., the size of any foreign substance that is produced in the imprint material container section as mentioned above is approximately a few tens of nm, which is small. When an imprint material channel is disposed in a filter having a small opening diameter that allows such foreign substance to be removed, the channel resistance (pressure loss) in the filter may slow down the supply of the imprint material to a discharging member, or may influence the discharge of the imprint material.

Therefore, the present invention provides an imprint material discharging device that is capable of properly discharging an imprint material from a discharging member while properly removing any foreign substance that is produced in the imprint material in a container section by using a filter.

An embodiment of the present invention is hereunder described with reference to the drawings.

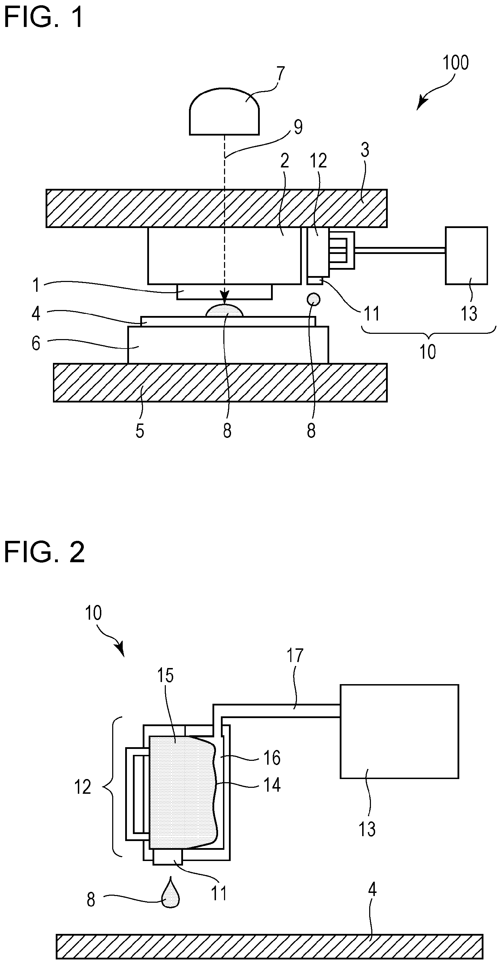

Fig. 1 illustrates a structure of an imprint apparatus 100. Here, an apparatus that cures an ultraviolet curable resin, used as an imprint material, by irradiating it with ultraviolet light is exemplified. However, the imprint material and the curing method are not limited thereto. For example, a photo-curable resin may be cured by irradiating it with light having wavelengths other than those of ultraviolet light by using a light irradiation device, or a thermosetting resin may be cured with heat.

The imprint apparatus 100 shown in Fig. 1 includes an imprint material discharging device 10 and a mold 1. The imprint apparatus 100 including the mold 1 and the imprint material discharging device 10 may be separately provided. That is, the imprint material may be discharged by the imprint material discharging device 10, and the mold of the imprint apparatus 100 that is provided separately from the imprint material discharging device 10 may be used to perform imprinting.

The imprint material discharging device 10 includes an imprint material discharging member 11, a container member 12 including a container section 15 for containing the imprint material, and a pressure control member 13. A substrate 4 is provided on a stage 6. An imprint material 8 is discharged onto the substrate 4 from the discharging member 11. The mold 1 is brought into contact with the imprint material 8 that has been discharged onto the substrate. In this state, the imprint material 8 is irradiated with ultraviolet light emitted from an ultraviolet light irradiation device 7, and is cured. A fine irregular pattern or the like is formed in the mold 1. When the mold 1 is moved upward, the imprint material is in a state in which the pattern of the mold has been transferred to the imprint material. In this way, the pattern is formed on the imprint material.

The stage 6 is movable along a base frame 5 while the stage 6 holds the substrate 4. A mold driving mechanism 2 that vertically drives the mold 1 is held by a structure 3. The mold driving mechanism 2 is capable of bringing the mold 1 towards the substrate 4, and bringing the mold 1 into contact with the imprint material 8. The ultraviolet light irradiation device 7 exists above the mold 1, and irradiates the imprint material 8 with ultraviolet light 9 via the mold 1. The ultraviolet light 9 may be generated from, for example, a light source such as a halogen lamp that generates an i-line and a g-line. The ultraviolet light irradiation device 7 may have a function of condensing light generated from the light source.

An imprint operation using the imprint apparatus 100 is described in detail. First, the substrate 4 is placed on the stage 6. The stage 6 moves the substrate 4 to a location that is underneath the discharging member 11 of the imprint material discharging device 10. While moving the stage 6, the imprint material 8 is discharged onto the substrate 4 from the discharging member 11.

Next, the stage 6 moves a portion of the substrate 4 onto which the imprint material 8 has been discharged to a location that is underneath the mold 1. Further, the mold driving mechanism 2 lowers the mold 1, and brings the mold 1 close to the substrate 4. In this state, an alignment scope or the like causes an alignment mark on the mold 1 and an alignment mark on the substrate to overlap, so that the position of the mold 1 and the position of the substrate 4 are aligned relative to each other.

After aligning the positions relative to each other, the mold driving mechanism 2 moves the mold 1 further downward (in the direction of the substrate 4), and causes the mold 1 to contact the imprint material 8. Thereafter, the ultraviolet light irradiation device 7 emits the ultraviolet light 9, and applies the ultraviolet light 9 transmitted through the mold 1 to the imprint material 8. As a result, a photo-curing reaction occurs in the imprint material 8, so that the imprint material 8 is cured.

Finally, the mold driving mechanism 2 separates the mold 1 from the cured imprinted material 8. By performing the above-described steps, it is possible to form a pattern on the substrate 4 (that is, a patterned imprint material). The imprint apparatus that is used in manufacturing a semiconductor may be used to form a pattern over the entire region of the substrate 4. In such a case, the imprint operation is repeated with respect to the substrate while changing the regions of the substrate on which the imprint operation is performed.

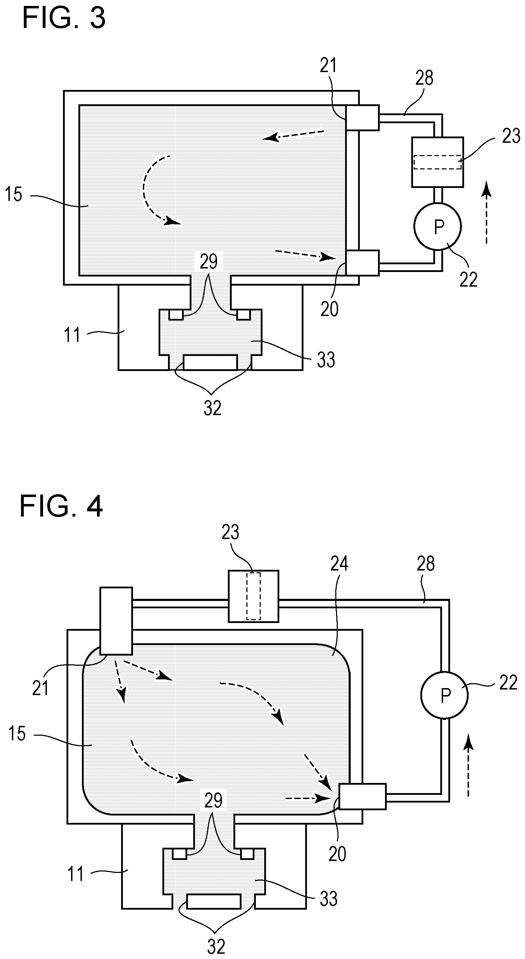

Next, the imprint material discharging device is described. Fig. 2 is a schematic view of the imprint material discharging device 10. The imprint material discharging device 10 primarily includes the discharging member 11, the container member 12, and the pressure control member 13. A separation membrane 14 that separates a space in the container section is provided in the container member 12. The separation membrane 14 is a membrane that separates the imprint material and a filling liquid (described below), and is desirably flexible. It is desirable that the thickness of the separation membrane 14 be from 10 µm to 200 µm. It is desirable that the separation membrane 14 be made of a liquid or a gaseous material having low transmissivity. For example, the separation membrane 14 may be formed from an aluminum multilayer film. Of the spaces formed by the separation membrane 14, the space that communicates with the discharging member 11 is filled with the imprint material. The discharging member 11 includes energy generating elements 29 that generate energy for discharging the imprint material. The discharging member 11 is shown in enlarged form in Fig. 3. The discharging member 11 has a discharge port 32 for discharging the imprint material, and a region 33 that is formed between each energy generating element 29 and the discharge port 32. Examples of the energy generating elements 29 include piezoelectric elements and heat generating resistors. Since materials that contain a large amount of resin are frequently used as the imprint material, it is desirable to use piezoelectric elements as the energy generating elements. By controlling the energy generating elements 29 by a controller, the imprint material 8 in the region 33 between each energy generating element 29 and the discharge port 32 is discharged onto the substrate from the discharge port 32. It is desirable that the discharging member 11 be a liquid discharging head that is used for, for example, an inkjet head. Alternatively, a discharging member that controls the supply of liquid and the stoppage of the supply of liquid by using a control valve or the like may also be used.

The discharging member 12 includes the container section 15 that contains the imprint material, and a filling liquid section 16 that is a space provided opposite to the container section 15 with the separation membrane 14 disposed therebetween and that is not connected to the discharging member 11. The filling liquid section 16 is filled with the filling liquid, and communicates with the pressure control member 13 via a communication portion 17. The pressure control member 13 includes, for example, a filling liquid tank, a pipe, a pressure sensor, a pump, and a valve. The pressure sensor, the pump, and the valve are used to control the pressure of the filling liquid in the filling liquid section. By controlling the pressure of the filling liquid by the pressure control member 13, it is possible to control the pressure of the imprint material in the container section 15 through the separation membrane 14. This makes it possible to stabilize the shape of a gas-liquid interface (meniscus) in the discharging member 11, and to discharge the imprint material with good reproducibility.

When the discharge of the imprint material 8 from the discharging member 11 is repeated, the imprint material in the container section 15 is consumed and is reduced in amount, so that the separation membrane 14 is deformed. As the separation membrane 14 is deformed, the filling liquid section 16 is replenished with filling liquid from the filling liquid tank by the pressure control member 13, so that the filling liquid section 16 is filled with the filling liquid.

The imprint material that is used in the imprint apparatus is required to maintain its properties until the imprint material is applied to the substrate with the amount of foreign substance (number of minute particles) and the number of metallic ions being minimized. In the present invention, until all of the imprint material is finally consumed as a result of the volume of the container section 15 being reduced due to repeated discharge of the imprint material, it is possible to store the imprint material while the imprint material is separated from the outside of the container section 15. Therefore, since the imprint material does not contact outside air and equipment such as the pressure sensor, it is possible to suppress the increase of foreign substances and metallic ions that have been initially controlled and sealed in.

In the container section 15, as the separation membrane, a bag-like flexible membrane, which is like an infusion bag, may be used. A gas-liquid interface may be formed in the container section 15. Alternatively, the container section 15 may be formed into a nonpressure type by connecting an air communication port to the container section 15. When the container section 15 is formed into a nonpressure type, in order to perform proper negative pressure control, it is desirable that the container section 15 be connected to an on-off valve or a device that controls the pressure.

In the field of inkjet recording devices, in order to stabilize the shape of the meniscus at the discharge port of the discharging member, the discharging member is designed such that the interior of the discharging member is maintained at a negative pressure in a certain range. For example, a method for generating negative pressure by utilizing capillary force in the interior of a porous material that is provided in the container section to retain a liquid is known. Other methods include a method for generating negative pressure in the container section by combining a mechanical element, such as a spring, and a balloon-like membrane, and a method for controlling negative pressure by utilizing a control valve and air pressure. Even in the present invention, the negative pressure in the container section may be controlled by such methods.

The imprint material discharging device according to the present invention has a structure in which a channel connected to the container section is provided outside the container member, and in which a filter is disposed in the channel. Fig. 3 illustrates an example of the imprint material discharging device according to the present invention. The channel (a channel formation member 28 that forms the channel) is connected to the container section 15 of the container member of the imprint material discharging device. The channel formation member 28 is a member in which the imprint material channel is formed, and is connected to the container section 15 through a first opening 20 and a second opening 21 that open into the container section 15. The first opening 20 is an opening that allows the imprint material in the container section 15 to be supplied into the channel. The second opening 21 is an opening that allows the imprint material supplied from the first opening 20 to be supplied into the container section 15. A pump 22 and a filter 23 that filters the imprint material are disposed in the channel that connects the first opening 20 and the second opening 21. When the possibility of production of foreign substance into the imprint material due to production of dust from the pump 22 is considered, it is desirable that the filter 23 be disposed downstream from the pump 22 in the direction of flow of the imprint material from the first opening 20 to the second opening 21. Although it is desirable that the pump 22 be provided in the channel of the channel formation member 28, the pump 22 may be provided outside the channel.

When the pump 22 is driven, the imprint material contained in the container section 15 is supplied (sucked) from the first opening 20. After the imprint material supplied from the first opening 20 has passed through and has been filtered by the filter 23 in the channel, the imprint material flows back into the container section 15 through the second opening 21. Then, the imprint material is supplied again from the first opening 20. That is, the imprint material in the container section 15 is circulated and filtered in the filter 23.

In this way, in the present invention, the filter 23 is disposed in the channel that communicates with the container section of the container member instead at a location between the discharging member and the container section of the container member. The imprint material supplied from the first opening 20 of the channel is supplied from the second opening 21 without passing through the region 33 between the discharge port and each energy generating element of the discharging member 11. The channel of the channel formation member 28 is provided at a portion that differs from the region 33 between the discharge port and each energy generating element. By virtue of such a structure, the ink print material is properly supplied to the discharging member 11, and is properly discharged from the discharge port 32 of the discharging member 11. An example of a structure in which the imprint material is circulated and filtered without passing through the region 33 consists in not disposing the region 33 on a straight line that connects the first opening 20 and the second opening 21 to each other.

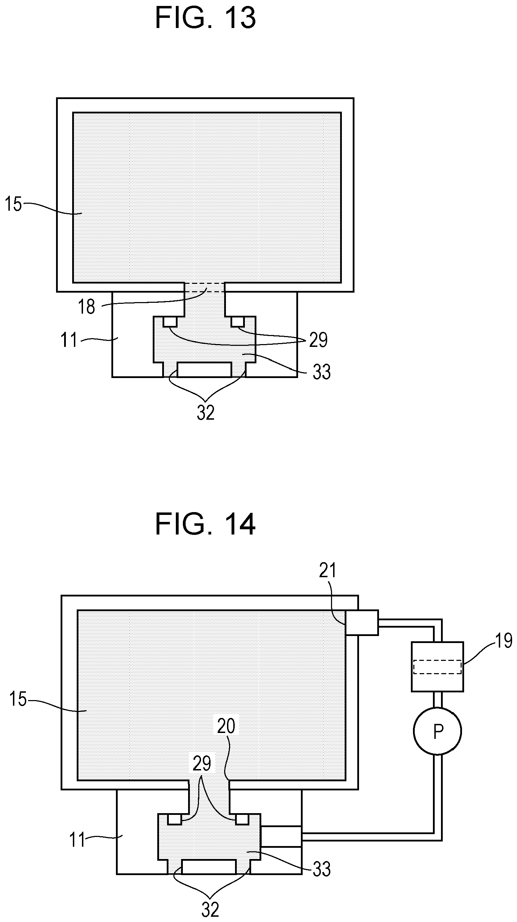

An imprint material discharging device shown in Fig. 13 is shown as a comparative example. Although the imprint material discharging device shown in Fig. 13 includes a filter 18 between the container section 15 of the container member and the discharging member 11, the imprint material discharging device shown in Fig. 13 does not have a channel in which the filter disposed as in the present invention. The structure shown in Fig. 13 allows the imprint material to be filtered at a location that is closest to the discharging member, and the filter is interposed between the container member and the discharging member, so that the structure is easily manufactured. From these viewpoints, such a structure is a practical structure. However, this means that the imprint material passes through the filter 18 when the imprint material is supplied from the container section 15 to the discharging member 11. As described above, the filter that is used in the imprint material discharging device has a small average aperture (that is, a small average opening diameter in the filter), and has a high channel resistance. Therefore, the supply of the imprint material into the discharging member 11 is slowed down, as a result of which the discharge of the imprint material from the discharging member 11 may be influenced.

In the present invention, it is desirable not to provide the filter between the container section 15 of the container member and the discharging member 11. Even if the filter is provided, the filter is required not to largely influence the supply of imprint material to the discharging member 11. The filter is at least required to be a filter having a channel resistance (pressure loss) that is less than that of the filter 23 in the channel, that is, is required to be a filter having an average aperture that is larger than that of the filter 23 in the channel.

The imprint material discharging device may be in the form of a cartridge that is removable from the imprint apparatus. For example, it is possible to set a state in which imprint can be immediately performed by mounting the imprint material discharging device having the form of a cartridge on the imprint apparatus and replacing the imprint material discharging device having the form of a cartridge after the imprint material in the container section 15 has been completely consumed. It is possible to integrate the pump 22 and the filter 23 with the imprint material discharging device as a cartridge, and replace them at the same time when replacing the imprint material discharging device. Such methods allow the imprint material discharging device to be replaced while minimizing the possibility of foreign substances mixing in the imprint material discharging device. Of the imprint material discharging device, only the container section 15 may be replaceable. That is, with the container section 15 being separable from the pump 22 and the filter 23, it is possible to replace only the container section 15. Since, for example, the pump 22 and the filter 23 are not replaced, this method is desirable from the viewpoint of costs.

The channel formation member 28 shown in Fig. 3 has the form of a tube. The channel in the channel formation member only needs to be formed outside the container section 15. For example, the channel in the channel formation member may be a channel formed in the container member by a cutting operation. The pump 22 and the filter 23 may be connected to the container section 15 by, for example, a tube to allow the pump 22 and the filter 23 to be separable through, for example, a removable joint or valve.

A material having high viscosity may be selected as the imprint material that is used in imprint techniques. In particular, if the discharging device has the form of a cartridge, it is desirable that the pump be small. Therefore, it is desirable that a structure be designed for efficiently filtering the imprint material by the filter 23. Consequently, openings of the channel are provided at the positions shown in Fig. 4. Compared to the imprint material discharging device shown in Fig. 3, the imprint material discharging device shown in Fig. 4 is such that two openings of the channel that open into the container section are positioned on a diagonal. That is, in the imprint material discharging device shown in Fig. 3, the first opening 20 and the second opening 21 open in the same side surface of the container section 15. In contrast, in the imprint material discharging device shown in Fig. 4, the first opening 20 opens in a side surface of the container section 15 and the second opening 21 opens in the top surface of the container section 15. That is, the first opening 20 and the second opening 21 open in different surfaces of the container section 15. By opening the first opening 20 and the second opening 21 in different surfaces of the container section 15, it is possible to efficiently circulate the imprint material in the container section 15. From the viewpoint of efficient circulation, it is desirable that the first opening 20 and the second opening 21 open in different surfaces, that is, in the top surface and a side surface of the container section 15; and it is more desirable that the first opening 20 open in a side surface of the container section 15 and the second opening 21 open in the top surface of the container section 15. In the specification, in causing the imprint material to flow along the channel from the first opening 20 to the second opening 21, among surfaces of the container section, a lower surface in the gravitational direction is a bottom surface, an upper surface in the gravitational direction is a top surface, and surfaces that connect the bottom surface and the top surface are side surfaces (four surfaces if the container section is a cube).

If a material (liquid) having high viscosity has, in particular, low inertial force when it flows, the material flows in a state in which its laminar flow is maintained without being agitated. Therefore, as in the flow denoted by arrows in Fig. 4, the imprint material supplied from the second opening 21 flows slowly without being spread and without any fluctuations in the container section 15, and is supplied to the first opening 20 while a portion of the imprint material replaces surrounding imprint material. Here, it is desirable that a corner 24 where the flow in the container section 15 tends to stagnate be curved (to have a rounded shape) as shown in Fig. 4. Such a shape makes it possible to suppress the stagnation of the imprint material at the corner 24.

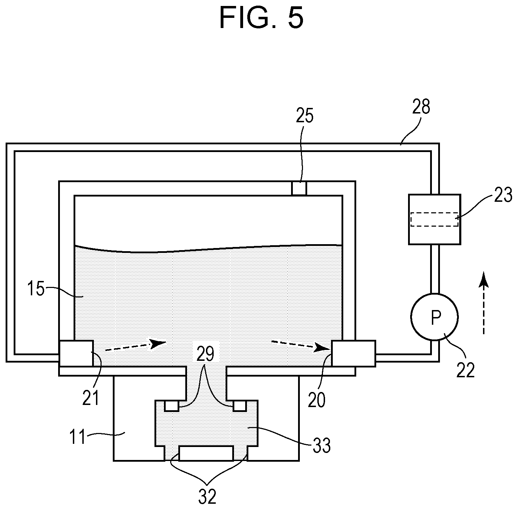

The first opening 20 and the second opening 21 may be disposed as shown in Fig. 5. That is, the first opening 20 and the second opening 21 may open in two opposite side surfaces of the container section 15. As shown in Fig. 5, if, as the imprint material is being consumed, gas (air) enters the container section 15 from an air communication port 25 that communicates with the air, it is desirable that the first opening 20 and the second opening 21 open in portions of side surfaces of the container section 15 that are closer to the bottom surface than to the top surface. By disposing the first opening 20 and the second opening 21 in this way, it is possible to circulate and filter the imprint material just before the liquid is consumed and the container section 15 runs out of the liquid.

By, as shown in Figs. 4 and 5, disposing the first opening 20 and the second opening 21 such that a channel that communicates with the discharging member 11 (that is, a portion in the container section that is disposed above an opening that communicates with the discharging member) is disposed therebetween, it is possible to efficiently replace the imprint material in the container section 15. This makes it possible to properly remove any foreign substance that is produced in the imprint material in the container section 15.

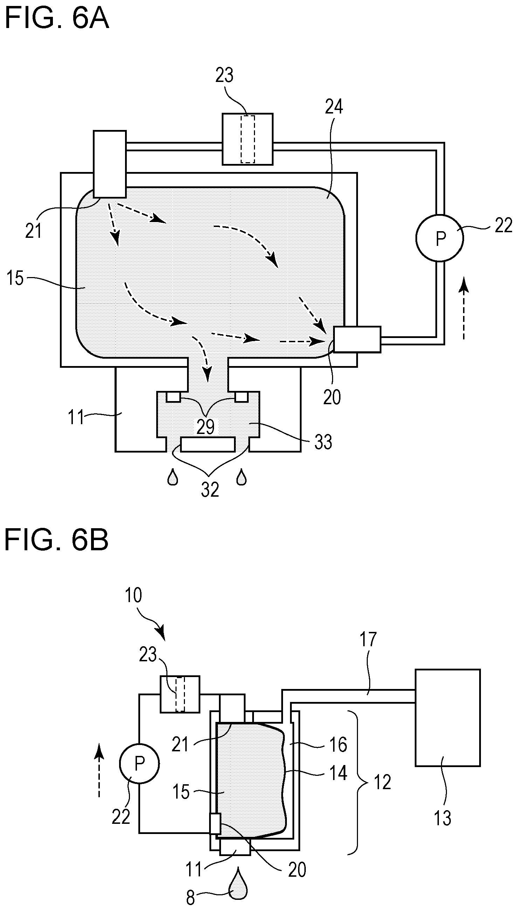

In order to increase the efficiency with which the imprint material is replaced, as mentioned up until now, it is desirable to circulate and discharge the imprint material. More specifically, as shown in Fig. 6A, while circulating the imprint material in the container section 15, the imprint material is caused to flow towards the region 33 and is discharged from the discharge port 32. Since the imprint material flows downward towards the discharging member 11 from the container section 15 by the discharging operation, the flow of the imprint material 15 in the container section 15 when it is circulated and filtered becomes a flow that passes near a communication port between the container section 15 and the discharging member 11. Further, when the imprint material that is circulated and filtered stagnates in the container section 15, it is possible to change the flow of the imprint material by the discharging operation, and to eliminate the stagnation of the imprint material. As a result, it is possible to increase the efficiency with which the imprint material that is supplied to the region 33 is replaced.

In order to discharge the imprint material described above, for example, as shown in Fig. 6B, when the discharging operation is performed, the pressure control member 13, which is pressure adjusting means, applies pressure to the internal portion of the filling liquid section 16 in the container member 12 through the communication portion 17. When the pressure control member 13 applies pressure to the internal portion of the filling liquid section 16, pressure is also applied to the interior of the container section 15 that contains the imprint material through the separation membrane 14. As a result, the imprint material in the container section 15 passes through the communication port disposed between the container section 15 and the discharging member 11, flows into the region 33 of the discharging member 11, and is discharged from the discharge port 32. The amount of imprint material that is discharged from the discharge port 33 (discharge amount) may be determined on the basis of at least one of the supply amount and the supply flow rate of the imprint material that is supplied from the first opening 20 to the second opening 21 when the imprint material is circulated and is filtered. That is, the pressure may be adjusted by the pressure adjusting means on the basis of at least one of the supply amount and the supply flow rate of the imprint material that is supplied from the first opening 20 to the second opening 21 when the imprint material is circulated and filtered. Therefore, information regarding the discharge amount is previously acquired by conducting experiments or the like such that the efficiency with which the imprint material in the container section 15 is replaced becomes a maximum in accordance with the remaining amount of imprint material in the container section 15 and the supply flow rate and the supply time when the imprint material is circulated and filtered. On the basis of the acquired information, the discharge amount is determined. In determining the discharge amount, the pressure application time and the pressure value of the pressure application to the internal portion of the container section 15 are also determined.

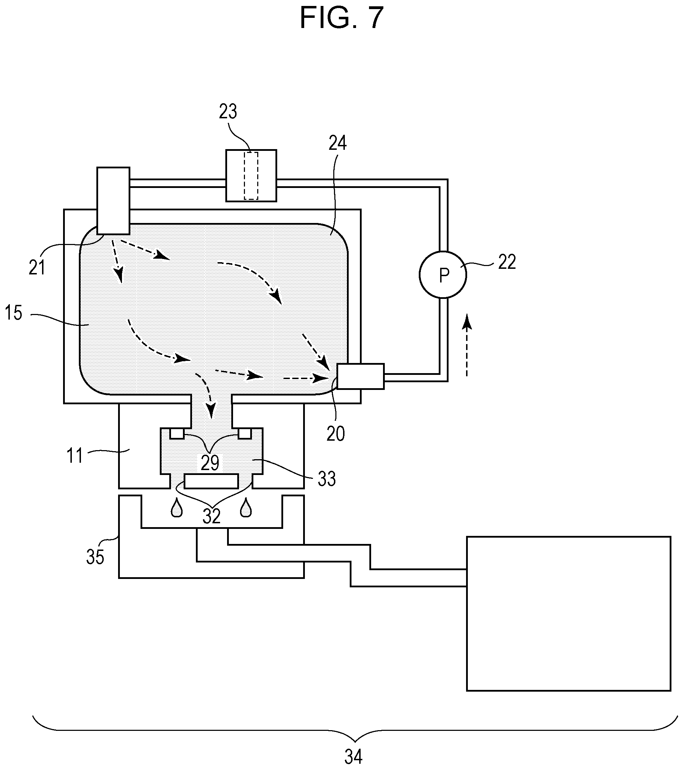

Instead of discharging the imprint material in the container section 15 by the pressure control member 13, as shown in Fig. 7, it is possible to discharge the imprint material by a suction controlling member 34, which is sucking means that sucks the imprint material from the discharge port 32. The suction controlling member 34 includes, for example, a sucking section, a pipe, a pressure sensor, a valve, and a negative pressure generating section. The sucking section of the suction controlling member 34 is disposed below the discharge port 32 during the discharging operation, the negative pressure generating section adjusts the pressure such that a portion that is lower than a top portion of a meniscus surface at the discharge port 32 has a negative pressure through the suction section 35, and the imprint material is discharged. When the imprint material is discharged by the suction controlling member 34, the suction amount or the suction flow rate of the imprint material may be determined on the basis of at least one of the supply amount and the supply flow rate of the imprint material that is supplied from the first opening 20 to the second opening 21 when the imprint material is circulated and is filtered. Therefore, information regarding the discharge amount is previously acquired by conducting experiments or the like such that the efficiency with which the imprint material in the container section 15 is replaced becomes a maximum in accordance with the remaining amount of imprint material in the container section 15 and the supply flow rate and the supply time when the imprint material is circulated and filtered. On the basis of the acquired information, the discharge amount is determined. In determining the discharge amount, the suction time and the pressure value at the sucking section are also determined.

Instead of discharging the imprint material by the pressure controlling member 13 or the suction controlling member 34, it is possible to discharge the imprint material from the discharge port 32 by using the energy generating elements 29 of the discharging member 11. That is, by generating energy from the energy generating elements 29, it is possible to discharge the imprint material in the region 33 and replace the imprint material in the region 33 and the container section 15.

It is possible to set various discharge timings in accordance with the discharge states. The imprint material may be discharged at the same time that the imprint material is circulated and filtered, or the imprint material may be circulated and filtered and discharged after the imprint material has been circulated and filtered for a specified period of time. Alternatively, the imprint material may be circulated and filtered after previously discharging the amount of imprint material required to replace the imprint material that exists in the region 33.

When bubbles exist in a liquid discharge port, since the bubbles may cause the imprint material to be unstably discharged, a removing operation may be performed for removing the bubbles in the discharge port. In order to use the imprint material with good efficiency, the imprint material may be circulated and filtered during the removing operation for removing the bubbles. This makes it possible to efficiently replace the imprint material at the region 33 with the filtered imprint material that has been filtered, and to stably discharge imprint material having a small amount of foreign substance and a small number of metallic ions to the substrate.

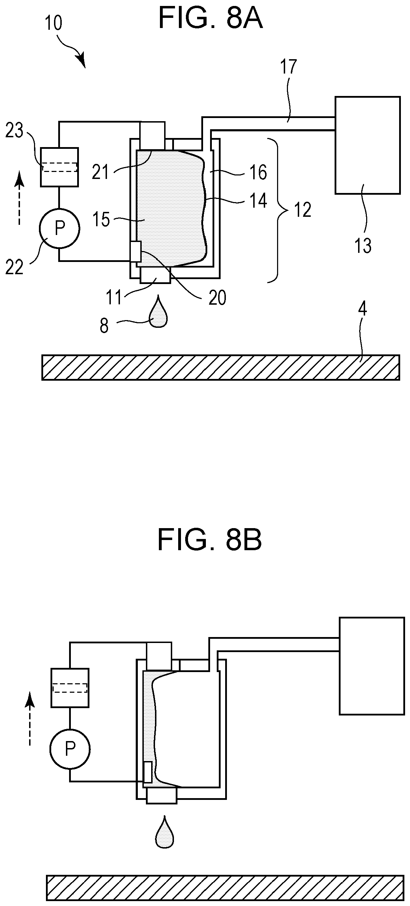

Figs. 8A and 8B illustrate states of the imprint material discharging device before and after the consumption of the imprint material. Fig. 8A illustrates the state before the consumption of the imprint material; and Fig. 8B illustrates the state after the consumption of the imprint material. As described above, the separation membrane 14 divides the interior of the container member 12 into the imprint material container section 15 and the filling liquid section 16. As the imprint material is consumed, the separation membrane 14 is deformed, and the volume of the container section 15 is reduced. In order to allow the imprint material to be circulated and filtered by the pump 22 and the filter 23 even if the separation membrane 14 moves, it is desirable to dispose the first opening 20 and the second opening 22 far away from the filling liquid section 16 (that is, at a side that is closer to the left side surface than to the right side surface in Fig. 8A) even in the container section 15.

Air may exist in the container section 15. For example, as shown in Fig. 5, air may be deliberately introduced therein. Alternatively, as shown in Fig. 4, although air is not positively introduced into the container section 15, when the imprint material is sealed in the container section 15, air may become mixed, or gas dissolved in the imprint material may be formed into air bubbles. When the air that exists in the imprint material is sent to the pump 22 and the filter 23, this may, for example, clog the pump 22 and the filter 23. Therefore, in order to minimize the sucking of the air by the first opening 20, it is desirable that, when the imprint material is being supplied from the first opening 20, the first opening 20 be disposed so as to open at a lower side of the container section in the gravitational direction. That is, it is desirable that the first opening 20 open at a location situated below the second opening 21 in the gravitational direction. In addition, it is desirable that the first opening 20 open at a location of a side surface of the container section 15 that is closer to the bottom surface than to the top surface.

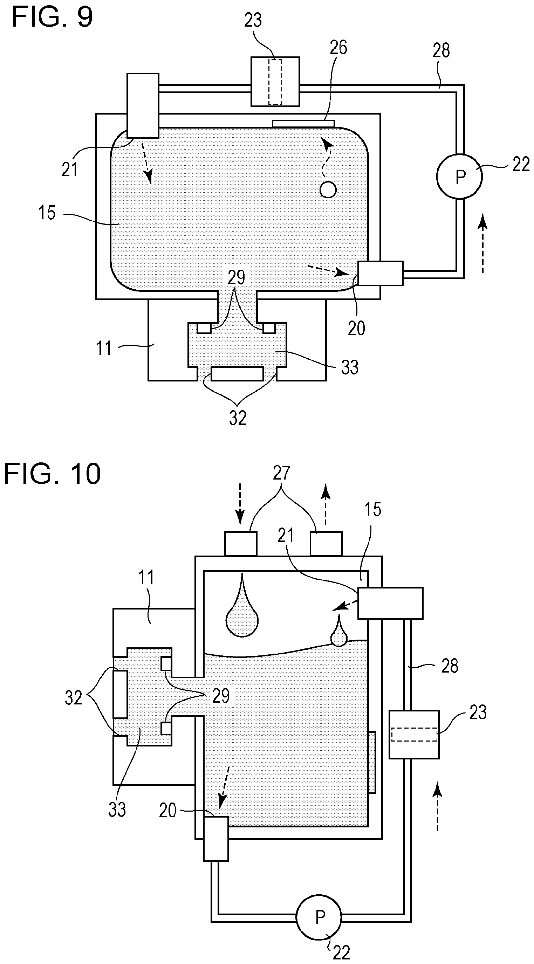

Due to buoyancy, the air (bubbles) in the imprint material moves towards the top surface, that is, upward in the gravitational direction in the container section 15. Therefore, as shown in Fig. 9, it is desirable to provide a trap space 26, which is a recess for trapping the air, in the top surface, which is the upper surface in the gravitational direction, of the container section 15. Since the air accumulates in the trap space 26, even if there is a gentle flow due to the circulation and filtering of the imprint material in the container section 15, it is possible to properly separate the air and the imprint material from each other.

As in the trap space 26, an air-liquid interface exists in the container section 15. When the air-liquid interface exists close to the second opening 21, the imprint material may bubble or air may mix in the imprint material. Therefore, it is desirable that the second opening 21 open at a location below the top surface of the container section 15 in the gravitational direction and below the air-liquid interface in the gravitational direction to supply the imprint material to the container section 15. Therefore, the second opening 21 may have a protruding shape that protrudes from the top surface of the container section 15, or a tube may be connected to the second opening 21 to guide an end of the tube to a location below the air-liquid interface.

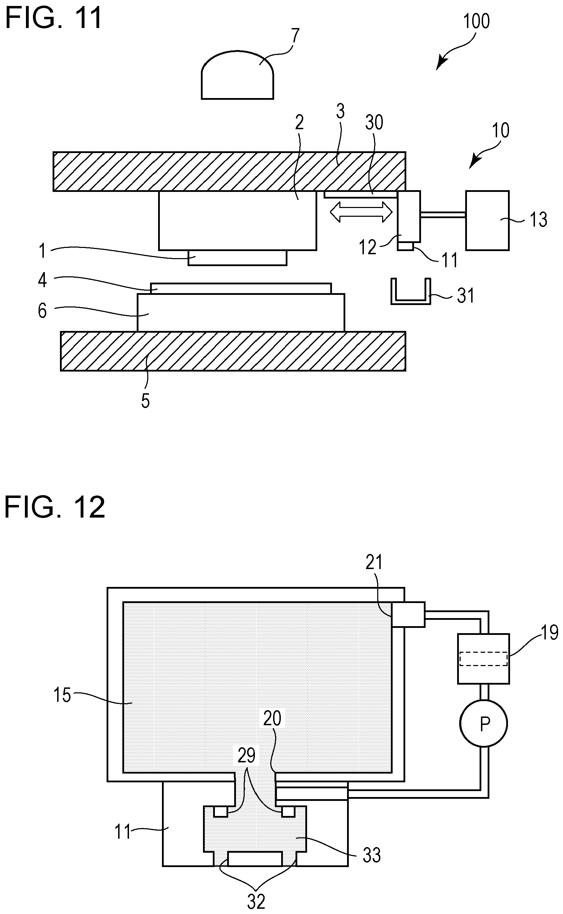

A channel may be formed through the discharging member 11. Such a structure is shown in Fig. 12. In this case, the channel extends from the first opening 20 to the second opening 21 through the interior of the discharging member 11. However, the region 33 is not provided in the channel through which the imprint material passes. That is, the imprint material supplied into the channel from the first opening 20 is supplied to the container section from the second opening 21 without passing through the region 33.

In the form shown in Fig. 12, since the first opening 20 opens close to the region 33, this form needs to be designed considering both the discharge of the imprint material and the filtering of the imprint material by the filter.

An example in which the imprint material supplied into the channel from the first opening 20 is supplied to the container section from the second opening 21 through the region 33 is shown in Fig. 14. In such a structure, it is difficult to achieve both proper discharge of the imprint material and proper filtering of the imprint material by the filter.

Next, a method for initially filling the container section 15 of the imprint material discharging device with the imprint material is described. As shown in Fig. 10, two imprint material filling ports 27 are provided in a side surface of the container section 15, and this side surface, that is, the filling ports 27 face upward in the gravitational direction when filling the container section 15 with the imprint material. The imprint material is supplied from one of the two filling ports 27, and air is supplied from the other of the two filling ports 27. When filling the container section 15 with the imprint material, an internal channel of the pump 22, an internal channel of the filter 23, etc. are also filled with the imprint material to make it less likely for the air to remain in the container section 15. Therefore, when the container section 15 is to be filled with the imprint material, it is desirable to drive the pump 22. When the pump 22 is driven, the air that initially exists in the internal channel of the pump 22, the internal channel of the filter 23, etc. is replaced by the imprint material, and exits from the second opening 21. Since the air is supplied from the closest filling port 27, it is possible to fill the channel that includes the container section 15 and the filter 23 without bubbling the imprint material more than necessary.

The container section may be filled with the imprint material not only at the initial stage but also during use of the imprint apparatus. For example, while filling the container section 15 with the imprint material from the filling port 27, the imprint apparatus may be used.

From the viewpoint of the structure of the filter 23, air tends to remain in the interior of the filter 23. By filling the filter 23 with the imprint material upward in the gravitational direction, it is possible to reduce the amount of air that remains therein. For example, as shown in Fig. 10, it is desirable that an upstream side of the filter 23 be disposed at a lower side in the gravitational direction and a downstream side of the filter 23 be disposed at an upper side in the gravitational direction when filling the filter 23 with the imprint material. It is desirable that, with the filter 23 disposed in this way, one of the filling ports 27 be disposed at the upper side in the gravitational direction to make it easier to supply the air from the container section 15. Further, it is desirable that the first opening 20 be disposed at the lower side in the gravitational direction to make it easier to fill the filter 23 with the imprint material.

When the filter 23 is a filter having an average aperture that is too large, it becomes difficult to sufficiently remove foreign substance in the imprint material. Therefore, the filter 23 is, desirably, a filter having an average aperture that is less than or equal to 10 nm, and, more desirably, a filter having an average aperture that is less than or equal to 5 nm. In contrast, when the filter 23 is a filter having an average aperture that is too small, it becomes difficult to circulate the imprint material in the channel due to pressure loss at the filter. Therefore, it is desirable that the filter 23 be a filter having an average aperture that is greater than or equal to 2 nm.

When the amount of foreign substance that exists in the imprint material is large, the filter may be clogged for a short period of time. Therefore, it is also desirable for the filter 23 to have a multiple filter structure in which, as a pre-filter, a filter that removes a large foreign substance is disposed on the upstream side in the direction of circulation, and a filter that removes a small foreign substance on the downstream side in the direction of circulation. The filter that removes a large foreign substance is, for example, a filter having an average aperture in the range of 50 nm to 200 nm. The filter that removes a small foreign substance is, for example, a filter having an average aperture in the range of 2 nm to 10 nm.

It is desirable that the filter 23 be of a membrane type or a hollow fiber membrane type. Such filters each include a plurality of fine holes in a membrane by which foreign substances are filtered and do not allow foreign substances having sizes that are greater than or equal to the aperture to pass therethrough. Examples of materials of which the filter is made include polyethylene, fluororesin, and nylon. The amount of metal that exists in the imprint material is required to be very small. Therefore, it is desirable to use a filter that absorbs the metal and that performs ion exchange. It is desirable that a plurality of such filters be disposed in series or in parallel.

As the pump 22, for example, a diaphragm pump, a syringe pump, a tube pump, or a gear pump may be used. It is desirable that the feeding flow rate of the pump 22 be less than or equal to 100 mL/min. When the flow rate is increased, the channel resistance (pressure loss) for passing the imprint material through the filter is increased. Therefore, the pump needs to be a high-output pump. Therefore, by using a pump having a feeding flow rate that is less than or equal to 20 mL/min, it is possible to reduce the size of the pump.

When pressure variations (pulsations) of the imprint material are large due to the driving of the pump, the imprint material tends to leak from the discharging member. Therefore, it is desirable to suppress the pressure variations to an amount that does not allow a meniscus at the discharge port to be broken. For example, it is desirable that the pump be driven such that the pressure variations are within ±300 Pa.

In order to operate the pump 22, the imprint material discharging device includes a controller. Since control is performed such that a certain flow rate is maintained to feed a liquid, when the filter 23 is clogged and the channel resistance is increased, driving voltage is increased. Therefore, when, at the controller, the driving voltage of the pump is monitored at all times, and the driving voltage exceeds a certain value, a warning that urges a user to replace the filter can be issued to the imprint apparatus. When the filter 23 is integrated into the imprint material discharging device having the form of a cartridge, the user can immediately use the imprint apparatus by replacing the imprint material discharging device. In order to detect any abnormality in the pump 22 and the filter 23, a sensor that monitors the states thereof may be provided, or, for example, a pressure sensor or a flow rate sensor may be formed in a pipe.

The imprint material discharging device is required to discharge very precise amounts of imprint material onto very precise landing locations on the substrate. Therefore, the shape of the meniscus at the discharge port of the discharging member needs to be stably maintained. In the imprint material discharging device, the pressure of the imprint material may vary as a result of the driving of the pump 22. Therefore, it is desirable that the driving of the pump 22 be stopped while the imprint material is being discharged from the imprint material discharging device.

In the imprint step, a pattern is formed on each region on the substrate while the discharge of the imprint material onto the substrate, the contacting of the mold from the imprint material, exposure, and the separation of the mold are repeated. Therefore, it is desirable that the imprint material be circulated and filtered at the container section 15 at a timing other than when the imprint material is being discharged onto the substrate. The timing at which the imprint material is circulated and filtered may be a timing at which the substrate or a lot is replaced.

The imprint material may be circulated and filtered when the amount of foreign substances, such as particles and gels, is increased in the container section 15. Therefore, the imprint material may be circulated and filtered when the apparatus is not operating. It is possible to stop the pump 22 when the imprint step is being executed, and circulate and filter the imprint material during maintenance of the apparatus or during a period of time in which a substrate on which an imprint operation is to be performed does not exist. It is possible to provide the imprint apparatus or the discharging device with a timer function, and circulate and filter the imprint material when a certain time has elapsed. It is also possible to control the pump 22 on the basis of a programmed instruction from the imprint apparatus or the discharging device, or perform a method in which the pump 22 is driven by a user.

Fig. 11 illustrates the imprint apparatus including a moving mechanism 30 for moving the container section. By the moving mechanism 30, the container member 12 can be moved between a location where the imprint material is discharged and a location where maintenance is performed. It is desirable that a receiving pan 31 that receives the imprint material that has come out from the discharging member 11 to be disposed at the location where maintenance is performed.

When the imprint material is circulated and filtered by causing the moving mechanism 30 to move the container member 12 to the location where maintenance is performed, even if the imprint material has leaked from the discharging member 11 due to large pressure variations, the imprint material can be received by the receiving pan 31. This is effective, for example, when one wants to return the process to the imprint step by quickly ending the circulation and filtering of the imprint material as a result of increasing the circulation and filtering flow rate by increasing the output of the pump 22.

The timing at which the imprint material is circulated and filtered may be determined in accordance with, for example, the time that has elapsed from the start of use of the imprint material discharging device of the imprint apparatus, the amount of use of the imprint material, the time that has elapsed from the previous circulation and filtering of the imprint material, and the storage environment history of the imprint material discharging device. Since the degree of gelation depends upon the environment and the type of imprint material, the degree of gelation may be determined on the basis of the type of imprint material.

When the remaining amount of imprint material decreases, the amount of imprint material that is circulated and filtered may be reduced, or conditions, such as the circulation and filtering timing and the flow rate, may be changed in accordance with the remaining amount of imprint material in the container section.

The pump 22 may be intermittently operated. When the pump 22 is controlled and driven at all times at a low flow rate, it is possible to suppress pressure variations. When a diaphragm pump is used as the pump 22, it is possible to, by reducing the vibration width of the diaphragm, suppress pressure variations and circulate and filter the imprint material at all times.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An imprint material discharging device (10) configured to discharge onto a substrate an imprint material on which a pattern is to be formed by bringing a mold into contact with the imprint material, the imprint material discharging device (10) comprising:
a container member (12) that includes a container section (15) configured to contain the imprint material;
a channel that is connected to the container section (15); and
a discharging member (11) that includes a discharge port (32) for discharging the imprint material, an energy generating element (29) that is configured to generate energy for discharging the imprint material from the discharge port (32), and a region (33) that is disposed between the energy generating element (29) and the discharge port (32),
wherein the channel has a first opening and a second opening, the first opening being configured to supply the imprint material contained in the container section (15) into the channel and opening into the container section (15),
**characterized by** the second opening being configured to supply the imprint material supplied from the first opening to the container section (15) and opening into the container section (15),
wherein a filter that is configured to filter the imprint material is disposed between the first opening and the second opening of the channel, and
wherein the channel is provided at a portion that differs from the region (33).

2. The imprint material discharging device (10) according to Claim 1, wherein the imprint material supplied into the channel from the first opening is supplied to the container section (15) from the second opening without passing through the region (33).

3. The imprint material discharging device (10) according to either Claim 1 or Claim 2, wherein the filter is not disposed between the container section (15) and the discharging member (11).

4. The imprint material discharging device (10) according to any one of Claims 1 to 3, wherein the energy generating element (29) is a piezoelectric element.

5. The imprint material discharging device (10) according to any one of Claims 1 to 4, wherein the container member (12) includes a separation membrane (14), and the separation membrane separates the container section (15) and a filling liquid section that is configured to be filled with a filling liquid.

6. The imprint material discharging device (10) according to Claim 5, wherein pressure of the imprint material in the container section (15) is controlled by controlling pressure of the filling liquid with which the filling liquid section is filled.

7. The imprint material discharging device (10) according to any one of Claims 1 to 6, wherein a pump is disposed in the channel that is provided between the first opening and the second opening.

8. The imprint material discharging device (10) according to Claim 7, wherein the pump is disposed upstream from the filter when the imprint material is supplied from the first opening to the second opening.

9. The imprint material discharging device (10) according to any one of Claims 1 to 8, wherein the region (33) does not exist on a straight line that connects the first opening and the second opening to each other.

10. The imprint material discharging device (10) according to any one of Claims 1 to 9, wherein the filter has an average aperture that is less than or equal to 10 nm.

11. The imprint material discharging device (10) according to any one of Claims 1 to 10, wherein when, in supplying the imprint material from the first opening to the second opening, among surfaces of the container section (15), a lower surface in a gravitational direction is a bottom surface, an upper surface in the gravitational direction is a top surface, and surfaces that connect the bottom surface and the top surface are side surfaces, the first opening and the second opening open in the same surface of the container section (15).

12. The imprint material discharging device (10) according to any one of Claims 1 to 10, wherein when, in supplying the imprint material from the first opening to the second opening, among surfaces of the container section (15), a lower surface in a gravitational direction is a bottom surface, an upper surface in the gravitational direction is a top surface, and surfaces that connect the bottom surface and the top surface are side surfaces, the first opening and the second opening open in different surfaces of the container section (15).

13. The imprint material discharging device (10) according to Claim 12, wherein the first opening and the second opening open in two opposite side surfaces among the side surfaces.

14. The imprint material discharging device (10) according to Claim 12, wherein the first opening opens in one of the side surfaces, and the second opening opens in the top surface of the container section (15).

15. The imprint material discharging device (10) according to any one of Claims 11 to 13, wherein the first opening and the second opening open in portions of the side surface that are closer to the bottom surface than to the top surface.

16. The imprint material discharging device (10) according to any one of Claims 1 to 15, wherein the container section (15) communicates with air via an air communication port.

17. The imprint material discharging device (10) according to any one of Claims 11 to 15 wherein the top surface is provided with a recess that traps air.

18. The imprint material discharging device (10) according to any one of Claims 1 to 17, wherein when supplying the imprint material from the first opening to the second opening, the imprint material in the container section (15) is discharged from the discharge port (32).

19. The imprint material discharging device (10) according to Claim 18, further comprising pressure adjusting means (13) arranged to adjust pressure in the container section (15), wherein the pressure adjusting means (13) is configured to cause the imprint material in the container section (15) to be discharged from the discharge port (32).

20. The imprint material discharging device (10) according to Claim 19, wherein the pressure adjusting means (13) is configured to adjust the pressure on the basis of at least one of a supply amount and a supply flow rate of the imprint material that is supplied from the first opening to the second opening.

21. The imprint material discharging device (10) according to Claim 18, further comprising sucking means (34) arranged to suck the imprint material from the discharge port (32), wherein when supplying the imprint material from the first opening to the second opening, the sucking means (34) sucks the imprint material in the container section (15) and causes the imprint material to be discharged from the discharge port (32).

22. The imprint material discharging device (10) according to Claim 21, wherein the sucking means (34) is configured to determine a suction amount or a suction flow rate of the imprint material on the basis of at least one of a supply amount and a supply flow rate of the imprint material that is supplied from the first opening to the second opening.

23. The imprint material discharging device (10) according to any one of Claims 1 to 22, wherein the container section (15) contains the imprint material.

24. An imprint apparatus (100) that forms a pattern on an imprint material on a substrate by bringing a mold into contact with the imprint material, the imprint apparatus (100) comprising:
the imprint material discharging device (10) according to any one of Claims 1 to 23 as an imprint material discharging device that is configured to discharge the imprint material onto the substrate.

25. The imprint apparatus (100) according to Claim 24, further comprising a light irradiation device (7) that is configured to cure the imprint material by irradiating the imprint material with light, wherein the imprint material is a photo-curable resin.

26. The imprint apparatus (100) according to either Claim 24 or 25, wherein the imprint material discharging device (10) is in the form of a cartridge that is removable from the imprint apparatus (100).

## Patentansprüche

1. Prägematerialausstoßvorrichtung (10), die konfiguriert ist, ein Prägematerial auf ein Substrat auszustoßen, auf dem ein Muster durch Herbeiführen eines Kontakts eines Formwerkzeugs mit dem Prägematerial gebildet werden soll, wobei die Prägematerialausstoßvorrichtung (10) umfasst:
ein Behälterbauteil (12), das einen zum Enthalten des Prägematerials eingerichteten Behälterabschnitt (15) umfasst;
einen mit dem Behälterabschnitt (15) verbundenen Kanal; und
ein eine Ausstoßöffnung (32) zum Ausstoßen des Prägematerials enthaltendes Ausstoßbauteil (11), ein zum Erzeugen von Energie zum Ausstoßen des Prägematerials aus der Ausstoßöffnung (32) eingerichtetes Energieerzeugungselement (29), sowie einen zwischen dem Energieerzeugungselement (29) und der Ausstoßöffnung (32) angeordneten Bereich (33),
wobei der Kanal eine erste und eine zweite Öffnung aufweist, wobei die erste Öffnung dazu eingerichtet ist, das im Behälterabschnitt (15) enthaltene Prägematerial in den Kanal zuzuführen und sich zum Behälterabschnitt (15) öffnet,
**gekennzeichnet durch** die zweite Öffnung, die dazu eingerichtet ist, das von der ersten Öffnung zugeführte Prägematerial zum Behälterabschnitt (15) zuzuführen und sich zum Behälterabschnitt (15) öffnet,
wobei ein zum Filtern des Prägematerials eingerichteter Filter zwischen der ersten und der zweiten Öffnung des Kanals angeordnet ist, und
wobei der Kanal an einem sich vom Bereich (33) unterscheidenden Abschnitt vorgesehen ist.

2. Prägematerialausstoßvorrichtung (10) nach Anspruch 1, wobei das von der ersten Öffnung in den Kanal zugeführte Prägematerial von der zweiten Öffnung in den Behälterabschnitt (15) zugeführt wird, ohne den Bereich (33) zu durchlaufen.

3. Prägematerialausstoßvorrichtung (10) nach Anspruch 1 oder Anspruch 2, wobei der Filter nicht zwischen dem Behälterabschnitt (15) und dem Ausstoßbauteil (11) angeordnet ist.

4. Prägematerialausstoßvorrichtung (10) nach einem der Ansprüche 1 bis 3, wobei das Energieerzeugungselement (29) ein piezoelektrisches Element ist.

5. Prägematerialausstoßvorrichtung (10) nach einem der Ansprüche 1 bis 4, wobei das Behälterbauteil (12) eine Trennungsmembran (14) enthält und die Trennungsmembran den Behälterabschnitt (15) und einen zum Füllen mit einer Füllflüssigkeit eingerichteten Füllflüssigkeitsabschnitt trennt.

6. Prägematerialausstoßvorrichtung (10) nach Anspruch 5, wobei Druck des Prägematerials im Behälterabschnitt (15) durch Steuerung von Druck der Füllflüssigkeit, mit der der Füllflüssigkeitsabschnitt gefüllt ist, gesteuert wird.

7. Prägematerialausstoßvorrichtung (10) nach einem der Ansprüche 1 bis 6, wobei eine Pumpe im Kanal angeordnet ist, die zwischen der ersten und der zweiten Öffnung vorgesehen ist.

8. Prägematerialausstoßvorrichtung (10) nach Anspruch 7, wobei die Pumpe stromaufwärtig vom Filter angeordnet ist, wenn das Prägematerial von der ersten Öffnung zur zweiten Öffnung zugeführt wird.

9. Prägematerialausstoßvorrichtung (10) nach einem der Ansprüche 1 bis 8, wobei der Bereich (33) nicht auf einer geraden Linie liegt, die die erste und die zweite Öffnung miteinander verbindet.

10. Prägematerialausstoßvorrichtung (10) nach einem der Ansprüche 1 bis 9, wobei der Filter eine mittlere Apertur aufweist, die weniger als oder gleich 10 nm beträgt.

11. Prägematerialausstoßvorrichtung (10) nach einem der Ansprüche 1 bis 10, wobei sich die erste und die zweite Öffnung in derselben Fläche des Behälterabschnitts (15) öffnen, wenn bei Zufuhr des Prägematerials von der ersten zur zweiten Öffnung von den Flächen des Behälterabschnitts (15) eine untere Fläche in einer Gravitationsrichtung eine unterste Fläche ist, eine obere Fläche in der Gravitationsrichtung eine oberste Fläche ist und Flächen, die die unterste und die oberste Fläche verbinden, seitliche Flächen sind.

12. Prägematerialausstoßvorrichtung (10) nach einem der Ansprüche 1 bis 10, wobei sich die erste und die zweite Öffnung in unterschiedlichen Flächen des Behälterabschnitts (15) öffnen, wenn bei Zufuhr des Prägematerials von der ersten zur zweiten Öffnung von den Flächen des Behälterabschnitts (15) eine untere Fläche in einer Gravitationsrichtung eine unterste Fläche ist, eine obere Fläche in der Gravitationsrichtung eine oberste Fläche ist und Flächen, die die unterste und die oberste Fläche verbinden, seitliche Flächen sind.

13. Prägematerialausstoßvorrichtung (10) nach Anspruch 12, wobei sich die erste Öffnung und die zweite Öffnung in zwei gegenüberliegende seitliche Flächen von den seitlichen Flächen öffnen.

14. Prägematerialausstoßvorrichtung (10) nach Anspruch 12, wobei sich die erste Öffnung in eine der seitlichen Flächen öffnet und sich die zweite Öffnung in die oberste Fläche des Behälterabschnitts (15) öffnet.

15. Prägematerialausstoßvorrichtung (10) nach einem der Ansprüche 11 bis 13, wobei sich die erste Öffnung und die zweite Öffnung in Abschnitten der seitlichen Flächen öffnen, die näher zur untersten Fläche sind als zur obersten Fläche.

16. Prägematerialausstoßvorrichtung (10) nach einem der Ansprüche 1 bis 15, wobei der Behälterabschnitt (15) über eine Luftverbindungsöffnung mit Luft in Verbindung steht.

17. Prägematerialausstoßvorrichtung (10) nach einem der Ansprüche 11 bis 15, wobei die oberste Fläche mit einer Vertiefung versehen ist, die Luft einschließt.

18. Prägematerialausstoßvorrichtung (10) nach einem der Ansprüche 1 bis 17, wobei bei Zufuhr des Prägematerials von der ersten zur zweiten Öffnung das Prägematerial im Behälterabschnitt (15) von der Ausstoßöffnung (32) ausgestoßen wird.

19. Prägematerialausstoßvorrichtung (10) nach Anspruch 18, ferner umfassend eine Druckanpassungseinrichtung (13), die zum Anpassen von Druck im Behälterabschnitt (15) ausgebildet ist, wobei die Druckanpassungseinrichtung (13) dazu eingerichtet ist, das Prägematerial im Behälterabschnitt (15) dazu zu veranlassen, von der Ausstoßöffnung (32) ausgestoßen zu werden.

20. Prägematerialausstoßvorrichtung (10) nach Anspruch 19, wobei die Druckanpassungseinrichtung (13) dazu eingerichtet ist, den Druck basierend auf einer Zufuhrmenge und/oder einer Zufuhrströmungsgeschwindigkeit des von der ersten Öffnung zur zweiten Öffnung zugeführten Prägematerials anzupassen.

21. Prägematerialausstoßvorrichtung (10) nach Anspruch 18, ferner umfassend eine Saugeinrichtung (34), die zum Ansaugen des Prägematerials von der Ausstoßöffnung (32) ausgebildet ist, wobei die Ansaugeinrichtung (34) bei Zufuhr des Prägematerials von der ersten Öffnung zur zweiten Öffnung das Prägematerial im Behälterabschnitt (15) ansaugt und das Prägematerial dazu veranlasst, von der Ausstoßöffnung (32) ausgestoßen zu werden.

22. Prägematerialausstoßvorrichtung (10) nach Anspruch 21, wobei die Ansaugeinrichtung (34) dazu eingerichtet ist, eine Ansaugmenge oder eine Ansaugströmungsgeschwindigkeit des Prägematerials basierend auf einer Zufuhrmenge und/oder einer Zufuhrströmungsgeschwindigkeit des aus der ersten Öffnung zur zweiten Öffnung zugeführten Prägematerials zu bestimmen.

23. Prägematerialausstoßvorrichtung (10) nach einem der Ansprüche 1 bis 22, wobei der Behälterabschnitt (15) das Prägematerial enthält.

24. Prägevorrichtung (100), die ein Muster auf einem Prägematerial auf einem Substrat bildet durch Herbeiführen eines Kontakts eines Formwerkzeugs mit dem Prägematerial, wobei die Prägevorrichtung (100) umfasst:
die Prägematerialausstoßvorrichtung (10) nach einem der Ansprüche 1 bis 23 als eine Prägematerialausstoßvorrichtung, die dazu eingerichtet ist, das Prägematerial auf das Substrat auszustoßen.

25. Prägevorrichtung (100) nach Anspruch 24, ferner umfassend eine Lichtbestrahlungsvorrichtung (7), die dazu eingerichtet ist, das Prägematerial durch Bestrahlen des Prägematerials mit Licht auszuhärten, wobei das Prägematerial ein lichthärtbares Harz ist.

26. Prägevorrichtung (100) nach einem der Ansprüche 24 oder 25, wobei die Prägematerialausstoßvorrichtung (10) eine von der Prägevorrichtung (100) entfernbare Kartusche ist.

## Revendications

1. Dispositif de décharge de matière d'impression (10) configuré pour décharger sur un substrat une matière d'impression sur laquelle un motif doit être formé en amenant un moule en contact avec la matière d'impression, le dispositif de décharge de matière d'impression (10) comprenant :
un organe récipient (12) configuré pour comprendre une section de récipient (15) qui contient la matière d'impression ;
un canal qui est relié à la section de récipient (15) ; et
un organe de décharge (11) qui comprend un orifice de décharge (32) pour décharger la matière d'impression, un élément générateur d'énergie (29) qui est configuré pour générer de l'énergie pour décharger la matière d'impression depuis l'orifice de décharge (32), et une région (33) qui est disposée entre l'élément générateur d'énergie (29) et l'orifice de décharge (32),
le canal comportant une première ouverture et une deuxième ouverture, la première ouverture étant configurée pour distribuer la matière d'impression contenue dans la section de récipient (15) jusque dans le canal et s'ouvrant dans la section de récipient (15),
**caractérisé par** la deuxième ouverture étant configurée pour distribuer la matière d'impression distribuée depuis la première ouverture jusqu'à la section de récipient (15) et s'ouvrant dans la section de récipient (15),
un filtre qui est configuré pour filtrer la matière d'impression étant disposé entre la première ouverture et la deuxième ouverture du canal, et
le canal étant situé en une partie qui diffère de la région (33).

2. Dispositif de décharge de matière d'impression (10) selon la revendication 1, dans lequel la matière d'impression distribuée jusque dans le canal depuis la première ouverture est distribuée jusqu'à la section de récipient (15) depuis la deuxième ouverture sans passer par la région (33).

3. Dispositif de décharge de matière d'impression (10) selon la revendication 1 ou la revendication 2, dans lequel le filtre n'est pas disposé entre la section de récipient (15) et l'organe de décharge (11).

4. Dispositif de décharge de matière d'impression (10) selon l'une quelconque des revendications 1 à 3, dans lequel l'élément générateur d'énergie (29) est un élément piézoélectrique.

5. Dispositif de décharge de matière d'impression (10) selon l'une quelconque des revendications 1 à 4, dans lequel l'organe récipient (12) comprend une membrane de séparation (14), et la membrane de séparation sépare la section de récipient (15) et une section de liquide de remplissage qui est configurée pour remplier d'un liquide de remplissage.

6. Dispositif de décharge de matière d'impression (10) selon la revendication 5, dans lequel la pression de la matière d'impression dans la section de récipient (15) est commandée en commandant la pression du liquide de remplissage avec laquelle la section de liquide de remplissage est remplie.

7. Dispositif de décharge de matière d'impression (10) selon l'une quelconque des revendications 1 à 6, dans lequel une pompe est disposée dans le canal qui est situé entre la première ouverture et la deuxième ouverture.

8. Dispositif de décharge de matière d'impression (10) selon la revendication 7, dans lequel la pompe est disposée en amont du filtre lorsque la matière d'impression est distribuée de la première ouverture à la deuxième ouverture.

9. Dispositif de décharge de matière d'impression (10) selon l'une quelconque des revendications 1 à 8, dans lequel la région (33) n'existe pas sur une ligne droite qui relie la première ouverture et la deuxième ouverture l'une à l'autre.

10. Dispositif de décharge de matière d'impression (10) selon l'une quelconque des revendications 1 à 9, dans lequel le filtre a une ouverture moyenne qui est inférieure ou égale à 10 nm.

11. Dispositif de décharge de matière d'impression (10) selon l'une quelconque des revendications 1 à 10, dans lequel, lorsque lors de la distribution de la matière d'impression de la première ouverture à la deuxième ouverture, parmi des surfaces de la section de récipient (15), une surface inférieure dans une direction de gravitation est une surface inférieure, une surface supérieure dans la direction de gravitation est une surface supérieure, et des surfaces qui relient la surface inférieure et la surface supérieure sont des surfaces latérales, la première ouverture et la deuxième ouverture s'ouvrent dans la même surface de la section de récipient (15) .

12. Dispositif de décharge de matière d'impression (10) selon l'une quelconque des revendications 1 à 10, dans lequel, lorsque lors de la distribution de la matière d'impression de la première ouverture à la deuxième ouverture, parmi des surfaces de la section de récipient (15), une surface inférieure dans une direction de gravitation est une surface inférieure, une surface supérieure dans la direction de gravitation est une surface supérieure, et des surfaces qui relient la surface inférieure et la surface supérieure sont des surfaces latérales, la première ouverture et la deuxième ouverture s'ouvrent dans des surfaces différentes de la section de récipient (15).

13. Dispositif de décharge de matière d'impression (10) selon la revendication 12, dans lequel la première ouverture et la deuxième ouverture s'ouvrent dans deux surfaces latérales opposées parmi les surfaces latérales.

14. Dispositif de décharge de matière d'impression (10) selon la revendication 12, dans lequel la première ouverture s'ouvre dans une des surfaces latérales, et la deuxième ouverture s'ouvre dans la surface supérieure de la section de récipient (15).

15. Dispositif de décharge de matière d'impression (10) selon l'une quelconque des revendications 11 à 13, dans lequel la première ouverture et la deuxième ouverture s'ouvrent dans des parties de la surface latérale qui sont plus proches de la surface inférieure que de la surface supérieure.

16. Dispositif de décharge de matière d'impression (10) selon l'une quelconque des revendications 1 à 15, dans lequel la section de récipient (15) communique avec l'air par le biais d'un orifice de communication d'air.

17. Dispositif de décharge de matière d'impression (10) selon l'une quelconque des revendications 11 à 15, dans lequel la surface supérieure est pourvue d'un évidement qui piège l'air.

18. Dispositif de décharge de matière d'impression (10) selon l'une quelconque des revendications 1 à 17, dans lequel lors de la distribution de la matière d'impression de la première ouverture à la deuxième ouverture, la matière d'impression dans la section de récipient (15) est déchargée de l'orifice de décharge (32).

19. Dispositif de décharge de matière d'impression (10) selon la revendication 18, comprenant, en outre, un moyen de réglage de pression (13) agencé pour régler la pression dans la section de récipient (15), le moyen de réglage de pression (13) étant configuré pour amener la matière d'impression dans la section de récipient (15) à être déchargée de l'orifice de décharge (32).

20. Dispositif de décharge de matière d'impression (10) selon la revendication 19, dans lequel le moyen de réglage de pression (13) est configuré pour régler la pression sur la base d'au moins un élément parmi une quantité de distribution et un débit de distribution de la matière d'impression qui est distribuée de la première ouverture à la deuxième ouverture.

21. Dispositif de décharge de matière d'impression (10) selon la revendication 18, comprenant, en outre, un moyen d'aspiration (34) agencé pour aspirer la matière d'impression depuis l'orifice de décharge (32), où, lors de la distribution de la matière d'impression de la première ouverture à la deuxième ouverture, le moyen d'aspiration (34) aspire la matière d'impression dans la section de récipient (15) et amène la matière d'impression à être déchargée de l'orifice de décharge (32).

22. Dispositif de décharge de matière d'impression (10) selon la revendication 21, dans lequel le moyen d'aspiration (34) est configuré pour déterminer une quantité d'aspiration ou un débit d'aspiration de la matière d'impression sur la base d'au moins un élément parmi une quantité d'aspiration et un débit d'aspiration de la matière d'impression qui est distribuée de la première ouverture à la deuxième ouverture.

23. Dispositif de décharge de matière d'impression (10) selon l'une quelconque des revendications 1 à 22, dans lequel la section de récipient (15) contient la matière d'impression.

24. Appareil d'impression (100) qui forme un motif sur une matière d'impression sur un substrat en amenant un moule en contact avec la matière d'impression, l'appareil d'impression (100) comprenant :
le dispositif de décharge de matière d'impression (10) selon l'une quelconque des revendications 1 à 23 en tant que dispositif de décharge de matière d'impression qui est configuré pour décharger la matière d'impression sur le substrat.

25. Appareil d'impression (100) selon la revendication 24, comprenant, en outre, un dispositif d'irradiation de lumière (7) qui est configuré pour durcir la matière d'impression en irradiant la matière d'impression avec de la lumière, la matière d'impression étant une résine photodurcissable.

26. Appareil d'impression (100) selon la revendication 24 ou 25, dans lequel le dispositif de décharge de matière d'impression (10) se présente sous la forme d'une cartouche qui est amovible de l'appareil d'impression (100).
